# EUROPEAN PATENT APPLICATION

(11) **EP 2 835 883 A1**
(43) Date of publication of application: **11.02.2015**
(21) Application number: 13876085.5
(22) Date of filing: 27.09.2013
(51) Int. Cl.: H01S 5/06, H04B 10/572, H01S 3/10

(54) **WAVELENGTH-ADJUSTABLE LASER OUTPUTTING METHOD AND ADJUSTABLE LASER DEVICE**

(30) Priority: 31.05.2013 CN 201310211285
(71) Applicant: Huawei Technologies Co., Ltd., Shenzhen, Guangdong 518129 (CN)
(72) Inventor: DAI, Xiquan, Shenzhen, Guangdong 518129 (CN)
(74) Representative: Pfenning, Meinig & Partner GbR
(86) International application number: PCT/CN2013/084376
(87) International publication number: WO 2014/190646

(57) **Abstract**

Embodiments of the present invention disclose a wavelength-tunable laser output method and a tunable laser apparatus. The method includes: adjusting, by a thermoelectric cooler according to a received control signal, a working temperature of a laser, so that the laser emits a multi-longitudinal mode optical signal corresponding to the current working temperature and the multi-longitudinal mode optical signal corresponds to a transmittance peak of a filter at a peak wavelength; performing, by the filter, filtering processing on the multi-longitudinal mode optical signal to obtain a single-frequency optical signal with a corresponding peak wavelength frequency; reflecting, by a reflector, a part of the single-frequency optical signal back to the laser; and locking, by the laser according to a center wavelength of the received single-frequency optical signal, an operating frequency, and generating and outputting a frequency-locking optical signal with a wavelength that is the same as the center wavelength of the single-frequency optical signal. In the embodiments of the present invention, a peak wavelength of a multi-longitudinal mode optical signal is changed by using a temperature, process the multi-longitudinal mode optical signal into a single-frequency optical signal that corresponds to a frequency of the peak wavelength, and lock the operating frequency of the laser, thereby achieving simple and cost-efficient output of a wavelength-tunable optical signal.

## Description

This application claims priority to Chinese Patent Application No. 201310211285.9, filed with the Chinese Patent Office on May 31, 2013 and entitled "WAVELENGTH-TUNABLE LASER OUTPUT METHOD AND TUNABLE LASER APPARATUS", which is incorporated herein by reference in its entirety.

### TECHNICAL FIELD

The present invention relates to the field of optical communications technologies, and in particular, to a wavelength-tunable laser output method and a wavelength-tunable laser apparatus.

### BACKGROUND

In a dense wavelength division multiplexing (DWDM) system and other optical communications fields, a laser light source whose wavelength is adjustable is required to achieve a flexible configuration of a network node and re-grooming of a wavelength. At present, commonly-used tunable lasers mainly include a sampled grating distributed Bragg reflector laser (SG-DBR laser), an External Cavity Tunable (ECL), and a tunable laser of a distributed feedback laser array (DFB Laser Array), and the like. Design of most of these tunable lasers is relatively complex and the price is high, which narrows applicable scope of this technology on a network device, especially an application on a short-haul metro wavelength division multiplexing network.

### SUMMARY

Embodiments of the present invention provide a wavelength-tunable laser output method and a tunable laser apparatus, to achieve a simple and cost-efficient wavelength-tunable laser output method. By changing a working temperature of the tunable laser apparatus, a center wavelength of a multi-longitudinal mode optical signal may be changed in a controllable manner, thereby achieving simple and cost-efficient output of a wavelength-tunable optical signal.

According to a first aspect, an embodiment of the present invention provides a wavelength-tunable laser output method, where the method includes:
adjusting, by a thermoelectric cooler, a working temperature of a laser according to a received control signal, so that the laser emits a multi-longitudinal mode optical signal corresponding to the current working temperature and the multi-longitudinal mode optical signal corresponds to a transmittance peak of a filter at a peak wavelength;
performing, by the filter, filtering processing on the multi-longitudinal mode optical signal, and acquiring a single-frequency optical signal corresponding to a frequency of the peak wavelength;
reflecting, by a reflector, a part of the single-frequency optical signal back to the laser; and
locking, by the laser, an operating frequency according to a center wavelength of the received single-frequency optical signal, and generating and outputting a frequency-locking optical signal with the same wavelength as the center wavelength of the single-frequency optical signal.

In a first possible implementation manner, the adjusting, by a thermoelectric cooler, a working temperature of a laser according to a received control signal, so that the laser emits a multi-longitudinal mode optical signal corresponding to the current working temperature and the multi-longitudinal mode optical signal corresponds to a transmittance peak of a filter at a peak wavelength specifically includes:
when the control signal is a first control signal, adjusting, by the thermoelectric cooler, the working temperature of the laser as a first temperature according to the received first control signal, so that the laser emits a first multi-longitudinal mode optical signal corresponding to the first working temperature and the first multi-longitudinal mode optical signal corresponds to a transmittance peak of the filter at a first peak wavelength; and
when the control signal is a second control signal, adjusting, by the thermoelectric cooler, the working temperature of the laser as a second temperature according to the received second control signal, so that the laser emits a second multi-longitudinal mode optical signal corresponding to the second working temperature and the second multi-longitudinal mode optical signal corresponds to another transmittance peak of the filter at a second peak wavelength;
where the first temperature and the second temperature both fall within an allowable working temperature range of the laser; and when the first temperature is not equal to the second temperature, the first peak wavelength and the second peak wavelength are different.

In a second possible implementation manner, the method further includes:
detecting, by a backlight detector, light emitting power of the laser, generating and sending a corresponding power feedback signal to an external control circuit to control and stabilize the light emitting power of the laser, and generating a multi-longitudinal mode optical signal with a constant peak wavelength.

In a third possible implementation manner, the method further includes:
detecting, by a temperature detector, the working temperature of the laser and generating a corresponding temperature feedback signal, so that the laser to generate, according to the temperature feedback signal, a corresponding temperature adjustment signal to adjust the working temperature of the laser.

According to a second aspect, an embodiment of the present invention provides a tunable laser apparatus, including a thermoelectric cooler, a laser, a filter, and a laser; where
the thermoelectric cooler is configured to adjust a working temperature of the laser according to a received control signal;
the laser is configured to emit a multi-longitudinal mode optical signal corresponding to the current working temperature, where the multi-longitudinal mode optical signal corresponds to a transmittance peak of the filter at a peak wavelength;
the filter is configured to perform filtering processing on the multi-longitudinal mode optical signal and acquire a single-frequency optical signal corresponding to a frequency of the peak wavelength;
the reflector is configured to reflect a part of the single-frequency optical signal back to the laser; and

the laser is further configured to lock an operating frequency according to a center wavelength of the received single-frequency optical signal, and generate and output a frequency-locking optical signal with the same wavelength as the center wavelength of the single-frequency optical signal.

In a first possible implementation manner, the thermoelectric cooler is specifically configured to:
when the control signal is a first control signal, adjust, according to the received first control signal, the working temperature of the laser as a first temperature, so that the laser emits a first multi-longitudinal mode optical signal corresponding to the first working temperature and the first multi-longitudinal mode optical signal corresponds to a transmittance peak of the filter at a first peak wavelength; and
when the control signal is a second control signal, adjust, according to the received second control signal, the working temperature of the laser as a second temperature, so that the laser emits a second multi-longitudinal mode optical signal corresponding to the second working temperature and the second multi-longitudinal mode optical signal corresponds to another transmittance peak of the filter at a second peak wavelength; where the first temperature and the second temperature both fall within an allowable working temperature range of the laser, and when the first temperature is not equal to the second temperature, the first peak wavelength and the second peak wavelength are different.

In a second possible implementation manner, the apparatus further includes a backlight detector, configured to detect light emitting power of the laser, generate and send a corresponding power feedback signal to an external control circuit to control and stabilize the light emitting power of the laser, and generate a multi-longitudinal mode optical signal with a constant peak wavelength.

In a third possible implementation manner, the apparatus further includes a temperature detector, configured to detect the working temperature of the laser and generate a corresponding temperature adjustment signal; where the temperature adjustment signal is used to adjust the working temperature of the laser.

In a fourth possible implementation manner, the apparatus further includes an optical isolator, configured to prevent an optical signal from entering the laser by using the optical isolator.

In a fifth possible implementation manner, the laser, the filter, and the reflector are permanently installed on the thermoelectric cooler.

A wavelength-tunable laser output method and a tunable laser apparatus provided by the embodiments of the present invention control a temperature to change a peak wavelength of a multi-longitudinal mode optical signal generated by a laser and process the multi-longitudinal mode optical signal into a single-frequency optical signal that corresponds to a frequency of the peak wavelength. The single-frequency optical signal is used to lock an operating frequency of the laser, so that the laser generates and outputs a frequency-locking optical signal with the same frequency, thereby achieving simple and cost-efficient output of a wavelength-tunable optical signal.

### BRIEF DESCRIPTION OF DRAWINGS

FIG. 1 is a flowchart of a wavelength-tunable laser output method according to an embodiment of the present invention;
FIG. 2 is a first schematic diagram of a spectral characteristic of a wavelength-tunable laser output method according to an embodiment of the present invention;
FIG. 3 is a schematic diagram of locking of an IL-FP laser according to an embodiment of the present invention;
FIG. 4 is a second schematic diagram of a spectral characteristic of a wavelength-tunable laser output method according to an embodiment of the present invention;
FIG. 5 is a schematic diagram of a tunable laser apparatus according to an embodiment of the present invention;
FIG. 6 is a schematic diagram of an IL-FP laser according to an embodiment of the present invention;
FIG. 7 is a schematic diagram of a filter according to an embodiment of the present invention; and
FIG. 8 is a schematic diagram of another filter according to an embodiment of the present invention.

The following describes the technical solutions in the embodiments of the present invention with reference to the accompanying drawings and embodiments.

### DESCRIPTION OF EMBODIMENTS

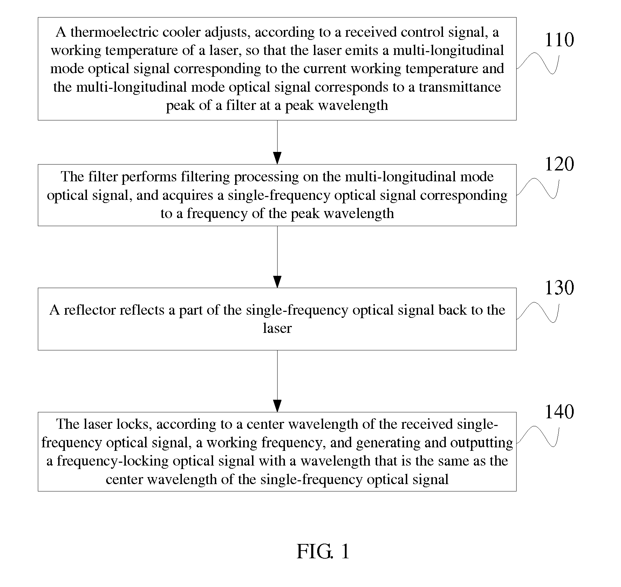

FIG. 1 is a flowchart of a wavelength-tunable laser output method according to an embodiment of the present invention. As shown in FIG. 1, the wavelength-tunable laser output method includes the following steps:
Step 110: A thermoelectric cooler adjusts, according to a received control signal, a working temperature of a laser, so that the laser emits a multi-longitudinal mode optical signal corresponding to the current working temperature and the multi-longitudinal mode optical signal corresponds to a transmittance peak of a filter at a peak wavelength.

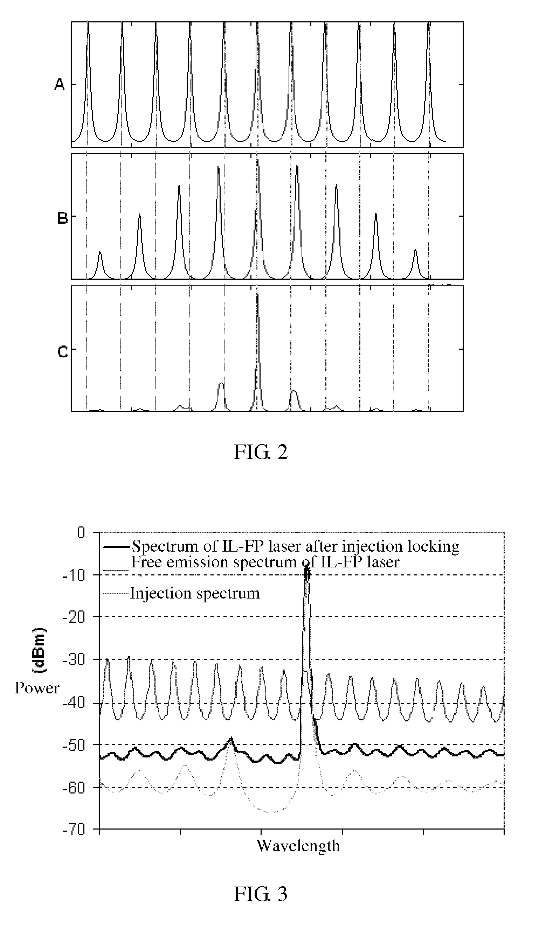

Specifically, an external control circuit sends a control signal to a tunable laser apparatus, where the control signal may be a direct current electrical signal and is received by the thermoelectric cooler of the tunable laser apparatus; the thermoelectric cooler of the tunable laser apparatus adjusts a temperature of the thermoelectric cooler according to the control signal, so that a temperature signal of the thermoelectric cooler on one end of the laser of the tunable laser apparatus is accordingly changed, that is, the temperature increases or decreases according to the control signal. Under a current working temperature, the laser receives an electric current signal sent from external circuit, and emits the multi-longitudinal mode optical signal after being excited by the electric current signal, and the temperature controlled and adjusted by the control signal may enable the multi-longitudinal mode optical signal to correspond to a transmittance peak of a filter at a peak wavelength. In a specific example, a spectral characteristic of the multi-longitudinal mode optical signal is shown in Figure B of FIG. 2, and a transmittance peak-frequency characteristic curve of the filter is shown in Figure A of FIG. 2. It can be seen that, in this specific example, a peak wavelength position of the multi-longitudinal mode optical signal corresponds to the transmittance peak of the filter. Preferably, the laser is an IL-FP laser.

After transmitting the multi-longitudinal mode optical signal, the laser performs collimation and focusing on the multi-longitudinal mode optical signal to maintain collimation of beam propagated, of the multi-longitudinal mode optical signal, between the laser of the tunable laser apparatus and the filter, so that the multi-longitudinal mode optical signal can be accurately transmitted to the filter.

Step 120: The filter performs filtering processing on the multi-longitudinal mode optical signal, and acquires a single-frequency optical signal corresponding to a frequency of the peak wavelength.

Specifically, when receiving the multi-longitudinal mode optical signal, the filter performs filtering processing on the multi-longitudinal mode optical signal and processes the multi-longitudinal mode optical signal into a single-frequency optical signal by means of filtering processing. In the foregoing specific example, after filtering processing is performed on a first multi-longitudinal mode optical signal shown in Figure B of FIG. 2, a single-frequency optical signal with a spectral characteristic shown in Figure C of FIG. 2 is obtained.

Step 130: A reflector reflects a part of the single-frequency optical signal back to the laser.

Specifically, by using partial reflection by the reflector, the single-frequency optical signal after filtering returns to the laser over an original light path and forms injection light of the laser.

Step 140: The laser locks, according to a center wavelength of the received single-frequency optical signal, an operating frequency, and generates and outputs a frequency-locking optical signal with a wavelength that is the same as the center wavelength of the single-frequency optical signal.

Specifically, the IL-FP laser has an injection locking feature and therefore works in an injection locking mode, and emits a frequency-locking optical signal with a wavelength that is the same as the center wavelength of partially-reflected single-frequency optical signal. The spectral characteristic of the frequency-locking optical signal is shown in FIG. 3. The center wavelength refers to a wavelength that corresponds to the maximum spectral luminous intensity or radiant power energy within a wavelength range.

After the frequency-locking optical signal is generated, the method further includes collimation and focusing for the frequency-locking optical signal, so that the frequency-locking optical signal can be accurately transmitted to an output optical fiber of the tunable laser apparatus, and the frequency-locking optical signal is transmitted over the output optical fiber. Therefore, the tunable laser apparatus externally provides a single-frequency laser signal with a certain center wavelength. The center wavelength of the frequency-locking optical signal is the same as the center wavelength of the single-frequency optical signal in the foregoing step 130, whereas the center wavelength of the single-frequency optical signal is obtained, by filtering, the multi-longitudinal mode optical signal generated by the laser at the current working temperature. Therefore, at a specific working temperature, according to a multi-longitudinal mode optical signal generated by a laser, a locking-frequency optical signal that is obtained by means of filtering processing and has a single frequency corresponding to a frequency of a peak wavelength of the multi-longitudinal mode optical signal may be output by using the foregoing method.

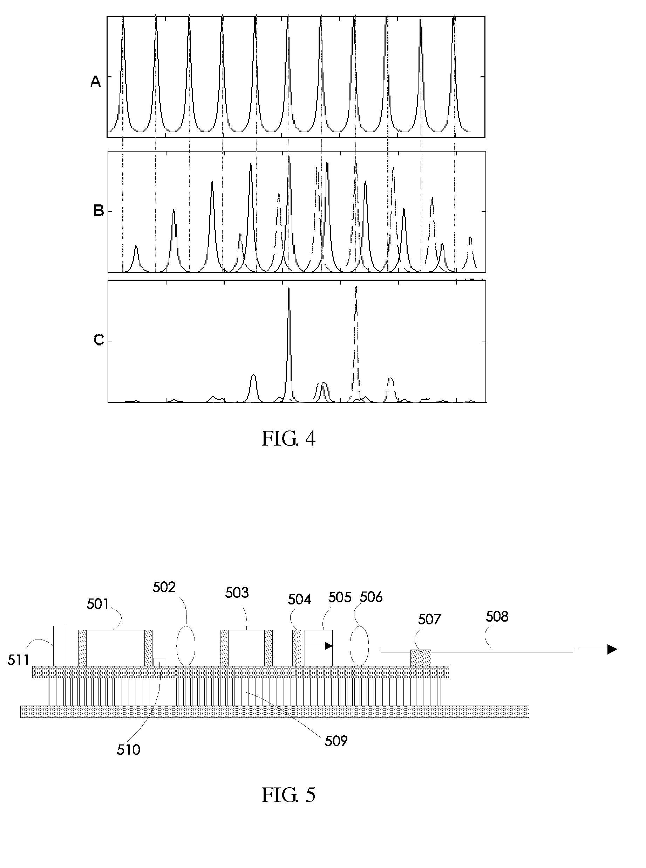

The foregoing embodiment describes a work principle of the tunable laser apparatus. With reference to FIG. 4, a wavelength adjustment principle of the tunable laser apparatus is described as follows:

When the control signal is a first control signal, a thermoelectric cooler adjusts, according to the received first control signal, a working temperature of a laser as a first temperature, so that the laser emits a first multi-longitudinal mode optical signal corresponding to the first working temperature and the first multi-longitudinal mode optical signal corresponds to a transmittance peak of the filter at a first peak wavelength; where the first temperature falls within an allowable working temperature range of the laser. In an example, a spectral characteristic of the first multi-longitudinal mode optical signal is shown in a solid line part in Figure B of FIG. 4, and a transmittance peak-frequency characteristic curve of the filter is shown in Figure A of FIG. 4. It can be seen that, the first peak wavelength of the first multi-longitudinal mode optical signal corresponds to a transmittance peak of a filter.

The filter performs filtering processing on the first multi-longitudinal mode optical signal to obtain a first single-frequency optical signal corresponding to a frequency of the first peak wavelength; a reflector reflects a part of the first single-frequency optical signal back to the laser, the laser locks an operating frequency of the first single-frequency optical signal according to a center wavelength of the received first single-frequency optical signal, and generates and outputs a first frequency-locking optical signal with a wavelength that is the same as the center wavelength of the first single-frequency optical signal. The first locking-frequency optical signal is shown in a solid line part in Figure C of FIG. 4.

When the control signal is changed, that is, the first control signal is changed to a second control signal, the thermoelectric cooler adjusts, according to the received second control signal, the working temperature of the laser as a second temperature, so that the laser emits a second multi-longitudinal mode optical signal corresponding to the second working temperature and the second multi-longitudinal mode optical signal corresponds to another transmittance peak of the filter at a second peak wavelength; where the second temperature also falls within the allowable working temperature range of the laser, and the first peak wavelength and the second peak wavelength are different when the first temperature is not equal to the second temperature. In this example, a spectral characteristic of the second multi-longitudinal mode optical signal is shown in a dotted line part in Figure B of FIG. 4, and the transmittance peak-frequency characteristic curve of the filter is further shown in Figure A of FIG. 4. It can be seen that, the second peak wavelength of the second multi-longitudinal mode optical signal corresponds to another transmittance peak of the filter. In addition, the second peak wavelength is different from the first peak wavelength, and transmittance peaks of the filter to which the first peak wavelength and the second peak wavelength correspond are also different. Therefore, a change of the temperature controlled by the control signal results in a change of the multi-longitudinal mode optical signal generated by the laser that occurs on a peak wavelength (that is, a frequency).

The filter performs filtering processing on the second multi-longitudinal mode optical signal to obtain a second single-frequency optical signal corresponding to a frequency of the second peak wavelength; the reflector reflects a part of the second single-frequency optical signal back to the laser, the laser locks an operating frequency of the second single-frequency optical signal according to a center wavelength of the received second single-frequency optical signal, and generates and outputs a second frequency-locking optical signal with a wavelength that is the same as the center wavelength of the second single-frequency optical signal. The second single-frequency optical signal is shown in a dotted line part in Figure C of FIG. 4.

Because frequencies of a peak wavelength (that is, the foregoing first peak wavelength and second peak wavelength) of a multi-longitudinal mode optical signal generated when a laser works at different working temperatures are different, frequencies of a first single-frequency optical signal generated based on the first peak wavelength and a second single-frequency optical signal generated based on the second peak wavelength are also different, and a wavelength (that is, a frequency) of a second frequency-locking optical signal generated by the laser locked by injecting the second single-frequency optical signal and a wavelength (that is, a frequency) of a first frequency-locking optical signal are also different. Therefore, an output of a wavelength-tunable optical signal may be achieved by controlling and changing a working temperature of a laser.

Preferably, a backlight detector of the tunable laser apparatus may further perform detection on light emitting power of the laser, and may generate a corresponding power feedback signal in real time and send the power feedback signal to an external control circuit, so that the external control circuit performs control and adjustment on the light emitting power of the laser according to the power feedback signal, thereby ensuring stability of the light emitting power of an optical signal generating module.

Preferably, a temperature detector of the tunable laser apparatus may further perform detection on the working temperature of the laser, and may generate a corresponding temperature feedback signal in real time and send the temperature feedback signal to an external control circuit, so that the external control circuit performs control and adjustment on the working temperature of the laser according to the temperature feedback signal and the laser can accurately work at a required temperature, thereby accurately acquiring a laser signal of a required wavelength.

The wavelength-tunable laser output method provided by this embodiment of the present invention controls a working temperature of a tunable laser apparatus to change a peak wavelength of a multi-longitudinal mode optical signal by using a temperature, and processes the multi-longitudinal mode optical signal into a single-frequency optical signal that corresponds to a frequency of the peak wavelength of the multi-longitudinal mode optical signal, and locks the operating frequency of the laser, thereby achieving simple and cost-efficient output of a wavelength-tunable optical signal. A wavelength range of the optical signal may cover band C and band L recommended by the International Telecommunication Union-Telecommunication Standardization Sector (ITU-T), or any other required wavelength range and wavelength spacing.

Accordingly, an embodiment of the present invention further provides a tunable laser apparatus, which is configured to implement the foregoing wavelength-tunable laser output method. As shown in FIG. 5, the tunable laser apparatus includes a thermoelectric cooler 509, an IL-FP laser 501, a filter 503, a reflector 504, and an output optical fiber 508.

The thermoelectric cooler 509 is configured to adjust, according to a received control signal, a working temperature of the laser.

Specifically, the control signal may be a direct current electrical signal. Heat flows from one end of the thermoelectric cooler 509 to the other end by loading certain current on both ends of the thermoelectric cooler 509. On the contrary, if current in a reverse direction is loaded to the thermoelectric cooler 509, heat flows from a reverse direction, thereby achieving heating or refrigerating. The thermoelectric cooler 509 may accurately control and enable a temperature on one end to decrease and a temperature on the other end to increase, or conversely. The IL-FP laser 501 is installed and fixed on the thermoelectric cooler 509. Therefore, whether heating or refrigerating the temperature of the thermoelectric cooler 509 may be controlled and changed by loading electrical signals in different directions or with different current, thereby changing a working temperature of the IL-FP laser that is fixed and installed on the thermoelectric cooler 509.

The IL-FP laser 501 is configured to emit a multi-longitudinal mode optical signal corresponding to the current working temperature, and the multi-longitudinal mode optical signal corresponds to a transmittance peak of the filter at a peak wavelength.

Specifically, the IL-FP laser 501 receives a driving signal sent by an external circuit and emits the multi-longitudinal mode optical signal after being excited by the driving signal.

The IL-FP laser 501 has a spectral characteristic that different multi-longitudinal mode optical signals are emitted according to different working temperatures, that is, if working temperatures received by the IL-FP laser 501 and provided by the thermoelectric cooler 509 are different, multi-longitudinal mode optical signals generated by the IL-FP laser 501 after being excited by the same electric current signal are different. If the working temperature of the IL-FP laser 501 is a first temperature, the IL-FP laser 501 generates a first multi-longitudinal mode optical signal; if the working temperature of the IL-FP laser 501 is a second temperature, the IL-FP laser 501 generates a second multi-longitudinal mode optical signal. When the first temperature is different from the second temperature, peak wavelengths of the foregoing first multi-longitudinal mode optical signal and second multi-longitudinal mode optical signal are different.

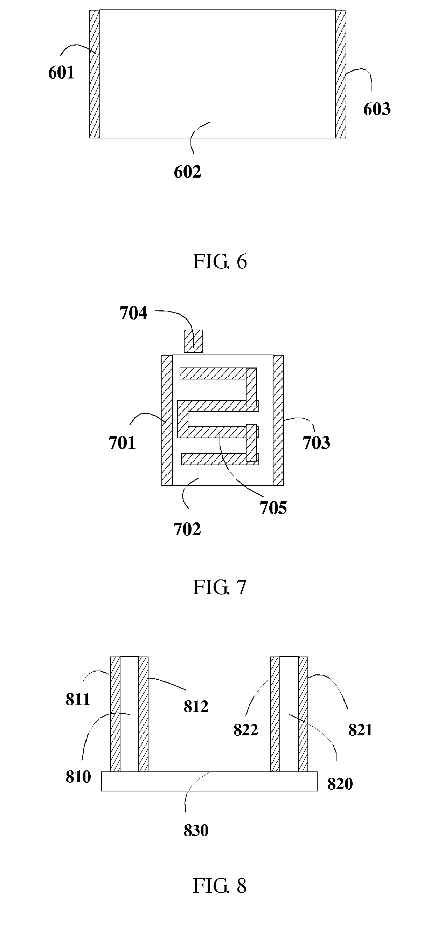

In a specific example, as shown in FIG. 6, the IL-FP laser 501 is formed by a rear end face coating film 601, a resonant cavity 602, and a front end face reflective film 603. The rear end face coating film 601 is a highly reflective film and the front end face reflective film 603 is a partial reflective film, so as to facilitate output of most of light and meanwhile further constitute the resonant cavity 602 to form free oscillation of the IL-FP laser 501.

A length of the resonant cavity 602 is determined according to a required frequency spacing. For example, if a 100G frequency spacing is required, the length may be calculated according to a formula Δf= C/2nL, where, f is a frequency of an optical signal, C is the speed of light, and Δf is a frequency spacing for different resonant modes.

The length of the resonant cavity L = C/2nΔf = 2.99792458 x 10⁸/ (2 x n x 100 x 10⁹) = 1.49896229/n (mm), where n is a refractive index of a semiconductor material that forms the resonant cavity.

The IL-FP laser 501 may be customized by using the foregoing implementation method.

The filter 503 is configured to perform filtering processing on the multi-longitudinal mode optical signal and acquire a single-frequency optical signal corresponding to a frequency of the peak wavelength.

Specifically, the filter 503 is permanently installed on the thermoelectric cooler 509, receives the multi-longitudinal mode optical signal sent by the IL-FP laser 501, performs filtering on the multi-longitudinal mode optical signal, and processes the multi-longitudinal mode optical signal into a single-frequency optical signal. A center wavelength of the single-frequency optical signal has a mapping relationship with the peak wavelength of the multi-longitudinal mode optical signal. When the thermoelectric cooler 509 controls and changes the working temperature of the IL-FP laser 501 according to the received control signal, the center wavelength of the single-frequency optical signal is also changed accordingly.

In addition, the center wavelength of the single-frequency optical signal that is generated after the multi-longitudinal mode optical signal is filtered may also be changed by changing a component parameter of the filter 503.

A Fabry-Perot etalon filter is preferably used as the filter 503. A specific implementation manner of the Fabry-Perot etalon filter includes two types, that is, solid cavity and air-filled cavity.

In a specific example, as shown in FIG. 7, the filter 503 is a Fabry-Perot etalon filter with a solid cavity, including reflective surfaces 701 and 703, a resonant cavity 702, a thermistor 704, and a heating resistor 705.

The two reflective surfaces 701 and 703 are both highly reflective films.

The resonant cavity 702 is made by using a solid and transparent material, for example, silicon dioxide (quartz glass), silicon, and the like materials.

A length of the resonant cavity 702 is determined according to a required free spectral range (FSR) of a filter. For example, if a 100G FSR spacing is required, the length may be calculated according to a formula Δf = C/2nL, where, f is a frequency of an optical signal, C is the speed of light, and Δf is a frequency spacing for different resonant modes. The length of the resonant cavity L = C/2nΔf = 2.99792458 x 10⁸/(2 x n x 100 x 10⁹) = 1.49896229/n (mm), where n is a refractive index of a material that forms the resonant cavity.

The thermistor 704 is configured to detect a working temperature of the filter 503 and provide a feedback to an external control circuit to perform temperature control.

The heating resistor 705 is configured to heat a cavity material of the filter 503 to maintain temperature stability of the filter 503. The heating resistor 705 may use a common power resistor spliced at a proper position on the filter 503, and a resistive film may also be directly made on the cavity material by using a thin film evaporation process.

In another specific example, as shown in FIG. 8, the filter 503 is a Fabry-Perot etalon filter with an air-filled cavity, including reflective surfaces 810 and 820, and a substrate material 830 for installing the reflective surfaces 810 and 820.

The two reflective surfaces 810 and 820 of the resonant cavity are formed by two identical emission coated sheets. The emission coated sheets are obtained by performing coating processing on materials such as silicon dioxide (quartz glass), silicon, and the like. Films 811 and 821 are anti-reflective films, and films 812 and 822 are highly reflective films.

830 is a substrate material for installing the two reflective surfaces 810 and 820 and may be made by using ceramics or quartz glass.

According to the foregoing calculation formula L=C/2nΔf, because a refractive index of air n = 1, when a required free spectral range FSR=100 GHz, the length of the cavity is L = 2.99792458 x 10⁸/(2 x 100 x 10⁹) = 1.49896229(mm).

The filter 503 may be customized by using the foregoing implementation method according to a requirement.

To ensure that the multi-longitudinal mode optical signal sent by the IL-FP laser 501 can be accurately transmitted to the filter 503, the tunable laser apparatus further includes a first collimation lens 502, placed between the IL-FP laser 501 and the filter 503, and configured to perform collimation and focusing on the multi-longitudinal mode optical signal, so as to maintain collimation of beam propagated, of the multi-longitudinal mode optical signal, between the IL-FP laser and the filter.

Reflector 504 is configured to reflect a part of the single-frequency optical signal to the laser 401.

Specifically, the reflector 504 is a partial reflector, placed perpendicular to an incidence direction of the single-frequency optical signal, is permanently installed on the thermoelectric cooler 509, and reflects a part of the single-frequency optical signal that is from the IL-FP laser 501 and filtered by the filter 503 and injects the part of the single-frequency optical signal into the IL-FP laser 501.

The IL-FP laser 501 is further configured to lock an operating frequency according to the center wavelength of the received single-frequency optical signal, and generate and output a frequency-locking optical signal with a wavelength that is the same as the center wavelength of the single-frequency optical signal.

Specifically, the IL-FP laser 501 enters an injection locking work mode according to the injected part of the single-frequency optical signal, and locks the operating frequency of the IL-FP laser 501 at the same frequency as the injected light. That is, the IL-FP laser 501 emits a frequency-locking optical signal with a wavelength that is the same as the center wavelength of the reflected part of the single-frequency optical signal.

The frequency-locking optical signal enters the output optical fiber 508 after traveling through the first collimation lens 502, the filter 503, a partial reflector 504, and a second collimation lens 506. The second collimation lens 506 is fixed on the thermoelectric cooler 509, placed between the partial reflector 504 and the output optical fiber 508, and configured to transmit the frequency-locking optical signal to the output optical fiber 508 in a collimation and focusing manner.

The output optical fiber 508 is configured to receive the frequency-locking optical signal generated by the IL-FP laser 501 and transmits the frequency-locking optical signal over an optical fiber.

Specifically, the output optical fiber 508 is fixed on the thermoelectric cooler 509 by using a fixing clip 507, and is aligned with an output optical path of the second collimation lens 506, thereby externally transmitting the frequency-locking optical signal over the output optical fiber 508.

When the thermoelectric cooler 509 controls the working temperature of the IL-FP laser 501 to be at the first temperature, the IL-FP laser 501 generates the first multi-longitudinal mode optical signal. The first multi-longitudinal mode optical signal is transmitted to the filter 503 through the first collimation lens 502 in a collimation and focusing manner. The filter 503 performs filtering on the first multi-longitudinal mode optical signal and processes the first multi-longitudinal mode optical signal into a single-frequency optical signal whose center wavelength is a first wavelength. The single-frequency optical signal is reflected back to the IL-FP laser 501 by using the partial reflector 504, and an operating frequency of the single-frequency optical signal is locked at a first frequency corresponding to the first wavelength. After injection and locking, the IL-FP laser 501 emits a frequency-locking optical signal whose center wavelength is the first wavelength. The frequency-locking optical signal enters the output optical fiber 508 and is externally transmitted after traveling through the first collimation lens 502, the filter 503, the partial reflector 504, and the second collimation lens 506.

When an operating wavelength of the tunable laser apparatus needs to be changed, the working temperature of the thermoelectric cooler 509 is changed from the first temperature to a second temperature, and the multi-longitudinal mode optical signal generated by the IL-FP laser 501 is changed from the first multi-longitudinal mode optical signal to a second multi-longitudinal mode optical signal with a center wavelength different from that of the first multi-longitudinal mode optical signal. The second multi-longitudinal mode optical signal is transmitted to the filter 503 through the first collimation lens 502 in a collimation and focusing manner. The filter 503 performs filtering on the second multi-longitudinal mode optical signal and processes the second multi-longitudinal mode optical signal into a second single-frequency optical signal whose center wavelength is a second wavelength. The second single-frequency optical signal is reflected back to the IL-FP laser 501 by using the partial reflector 504, and an operating frequency of the second single-frequency optical signal is locked at a second frequency corresponding to the second wavelength. After injection and locking, the IL-FP laser 501 emits a frequency-locking optical signal whose center wavelength is the second wavelength. The frequency-locking optical signal enters the output optical fiber 508 and is externally transmitted after traveling through the first collimation lens 502, the filter 503, the partial reflector 504, and the second collimation lens 506. Therefore, an output wavelength of the tunable laser apparatus is changed from the first wavelength to the second wavelength, achieving output of a wavelength-tunable optical signal.

Preferably, the tunable laser apparatus provided by this embodiment of the present invention further includes a backlight detector 511, which is permanently installed on the thermoelectric cooler 509 and is placed on a side reverse to a light emitting direction of the IL-FP laser 501, and is configured to detect light emitting power of the IL-FP laser 501, and may generate a corresponding power feedback signal in real time and send the power feedback signal to an external control circuit, so that the external control circuit performs control and adjusts on the light emitting power of the IL-FP laser 501 according to the power feedback signal, thereby ensuring stability of the light emitting power of the IL-FP laser 501.

Preferably, the tunable laser apparatus provided by this embodiment of the present invention further includes a temperature detector 510, which is permanently installed on the thermoelectric cooler 509 and is placed close to the IL-FP laser 501, and is configured to detect a working temperature of the IL-FP laser 501, and may generate a corresponding temperature feedback signal in real time and send the temperature feedback signal to the external control circuit, so that the external control circuit performs control and adjusts on the working temperature of the IL-FP laser 501 according to the temperature feedback signal, and the IL-FP laser 501 can accurately work at a required temperature, thereby accurately acquiring a laser signal with a required wavelength.

Preferably, the tunable laser apparatus provided by this embodiment of the present invention further includes an optical isolator 505, which is permanently installed on the thermoelectric cooler 509 and is placed between the partial reflector 504 and the second collimation lens 506, and is configured to prevent other external optical signals from entering the IL-FP laser 501 by using the optical isolator 504 to affect the locking working state of the IL-FP laser 501.

A tunable laser apparatus provided by this embodiment of the present invention controls a working temperature of an IL-FP laser to change a peak wavelength of a multi-longitudinal mode optical signal generated by a laser, and processes the multi-longitudinal mode optical signal into a single-frequency optical signal that corresponds to a frequency, of the peak wavelength and is configured to lock an operating frequency of the laser, so that the laser generates and outputs a frequency-locking optical signal with the corresponding frequency, thereby achieving the tunable laser apparatus that is simple and cost-efficient, and provides output of a wavelength-tunable optical signal. A wavelength range of the optical signal may cover band C and band L recommended by the International Telecommunication Union-Telecommunication Standardization Sector (ITU-T), or any other required wavelength range and wavelength spacing.

The objectives, technical solutions, and beneficial effects of the present invention are further described in detail in the foregoing specific embodiments. It should be understood that the foregoing descriptions are merely specific embodiments of the present invention, but are not intended to limit the protection scope of the present invention. Any modification, equivalent replacement, or improvement made within the spirit and principle of the present invention shall fall within the protection scope of the present invention.

## Claims

1. A wavelength-tunable laser output method, wherein the method comprises:
adjusting, by a thermoelectric cooler, a working temperature of a laser according to a received control signal, so that the laser emits a multi-longitudinal mode optical signal corresponding to the current working temperature and the multi-longitudinal mode optical signal corresponds to a transmittance peak of a filter at a peak wavelength;
performing, by the filter, filtering processing on the multi-longitudinal mode optical signal, and acquiring a single-frequency optical signal corresponding to a frequency of the peak wavelength;
reflecting, by a reflector, a part of the single-frequency optical signal back to the laser; and
locking, by the laser, an operating frequency according to a center wavelength of the received single-frequency optical signal, and generating and outputting a frequency-locking optical signal with a wavelength that is the same as the center wavelength of the single-frequency optical signal.

2. The wavelength-tunable laser output method according to claim 1, wherein the adjusting, by a thermoelectric cooler, a working temperature of a laser according to a received control signal, so that the laser emits a multi-longitudinal mode optical signal corresponding to the current working temperature and the multi-longitudinal mode optical signal corresponds to a transmittance peak of a filter at a peak wavelength comprises:
when the control signal is a first control signal, adjusting, by the thermoelectric cooler, the working temperature of the laser as a first temperature according to the received first control signal, so that the laser emits a first multi-longitudinal mode optical signal corresponding to the first working temperature and the first multi-longitudinal mode optical signal corresponds to a transmittance peak of the filter at a first peak wavelength; and
when the control signal is a second control signal, adjusting, by the thermoelectric cooler, the working temperature of the laser as a second temperature according to the received second control signal, so that the laser emits a second multi-longitudinal mode optical signal corresponding to the second working temperature and the second multi-longitudinal mode optical signal corresponds to another transmittance peak of the filter at a second peak wavelength;
wherein the first temperature and the second temperature both fall within an allowable working temperature range of the laser; and when the first temperature is not equal to the second temperature, the first peak wavelength and the second peak wavelength are different.

3. The wavelength-tunable laser output method according to claim 1, wherein the method further comprises:
detecting, by a backlight detector, light emitting power of the laser, generating and sending a corresponding power feedback signal to an external control circuit to control and stabilize the light emitting power of the laser, and generating a multi-longitudinal mode optical signal with a constant peak wavelength.

4. The wavelength-tunable laser output method according to claim 1, wherein the method further comprises:
detecting, by a temperature detector, the working temperature of the laser and generating a corresponding temperature feedback signal, so that the laser generates, according to the temperature feedback signal, a corresponding temperature adjustment signal to adjust the working temperature of the laser.

5. A tunable laser apparatus, wherein the apparatus comprises a thermoelectric cooler, a laser, a filter, and a reflector; wherein
the thermoelectric cooler is configured to adjust, according to a received control signal, a working temperature of the laser;
the laser is configured to emit a multi-longitudinal mode optical signal corresponding to the current working temperature, and the multi-longitudinal mode optical signal corresponds to a transmittance peak of the filter at a peak wavelength;
the filter is configured to perform filtering processing on the multi-longitudinal mode optical signal and acquire a single-frequency optical signal corresponding to a frequency of the peak wavelength;
the reflector is configured to reflect a part of the single-frequency optical signal back to the laser; and
the laser is further configured to lock, according to a center wavelength of the received single-frequency optical signal, an operating frequency, and generate and output a frequency-locking optical signal with a wavelength that is the same as the center wavelength of the single-frequency optical signal.

6. The tunable laser apparatus according to claim 5, wherein the thermoelectric cooler is specifically configured to:
when the control signal is a first control signal, adjust, according to the received first control signal, the working temperature of the laser as a first temperature, so that the laser emits a first multi-longitudinal mode optical signal corresponding to the first working temperature and the first multi-longitudinal mode optical signal corresponds to a transmittance peak of the filter at a first peak wavelength; and
when the control signal is a second control signal, adjust, according to the received second control signal, the working temperature of the laser as a second temperature, so that the laser emits a second multi-longitudinal mode optical signal corresponding to the second working temperature and the second multi-longitudinal mode optical signal corresponds to another transmittance peak of the filter at a second peak wavelength; wherein the first temperature and the second temperature both fall within an allowable working temperature range of the laser, and when the first temperature is not equal to the second temperature, the first peak wavelength and the second peak wavelength are different.

7. The tunable laser apparatus according to claim 5, wherein the apparatus further comprises a backlight detector, configured to detect light emitting power of the laser, generate and send a corresponding power feedback signal to an external control circuit to control and stabilize the light emitting power of the laser, and generate a multi-longitudinal mode optical signal with a constant peak wavelength.

8. The tunable laser apparatus according to claim 5, wherein the apparatus further comprises a temperature detector, configured to detect the working temperature of the laser and generate a corresponding temperature adjustment signal; wherein the temperature adjustment signal is used to adjust the working temperature of the laser.

9. The tunable laser apparatus according to claim 5, wherein the apparatus further comprises an optical isolator, configured to prevent an optical signal from entering the laser by using the optical isolator.

10. The tunable laser apparatus according to claim 5, wherein the laser, the filter, and the reflector are permanently installed on the thermoelectric cooler.
